# EUROPEAN PATENT SPECIFICATION

(11) **EP 0 367 076 B1**
(45) Date of publication and mention of the grant of the patent: **27.04.1994**
(21) Application number: 89119740.2
(22) Date of filing: 24.10.1989
(51) Int. Cl.: H05K 3/34, H01R 9/09, H05K 1/18, H05K 3/40

(54) **Throughput of a two-sided printed board and method for producing it**
Durchverbindung einer doppelseitigen Leiterplatte und Verfahren zu ihrer Herstellung
Connexion de traversée d'un panneau à circuit double face et procédé de fabrication d'une telle connexion

(30) Priority: 27.10.1988 FI 884971
(43) Date of publication of application: 09.05.1990
(73) Proprietor: SALORA OY, SF-241 00 Salo (FI)
(72) Inventor: Anttio, Markku Ilmari, SF-24260 Salo (FI); Suominen, Aarre Tapani, SF-25520 Perniö (FI)
(74) Representative: Strehl Schübel-Hopf Groening & Partner

(56) References cited:
- DE-A- 3 521 752
- DE-B- 1 065 898
- FR-A- 2 184 437
- US-A- 3 159 906

## Description

The present invention relates to the throughput of a two-sided printed board, in which the upper conductor foil of the printed board is connected directly or by means of a component with the lower conductor foil, the upper joint having been produced by a sleeve inserted into a hole in the printed board in such a manner that molten solder has risen through the sleeve from below the printed board and has fixed the top of the sleeve to the upper conductor foil.

It is known from FR-A-2 184 437 to form the throughput simply so as to place into the hole in the printed board, at the point of which a conductor foil is provided on each side, a metal sleeve, through which the molten solder rises by capillary force, thus soldering both the upper and the lower conductor foil to the sleeve. Although such a joint is extremely easy to produce, one of its drawbacks is that the solder joint might break because of the stiffness of the joint and of the different thermal expansion coefficients of the printed board and the sleeve material, particularly if the printed board is subject to temperature variations. When the temperature variations continue, the rupture grows and may eventually lead to an electric break. This problem can be somewhat reduced by using a printed board material having more advantageous thermal expansion characteristics (e.g. glass fibre material FR-4), but such a material is more expensive as well as harder to work.

DE-A-3 521 752 discloses a throughput of a two-sided printed board, in which the upper conductor foil is connected directly or by means of a component with the lower conductor foil, the upper joint having been produced in such a manner that molten solder has fixed one arm of the wire, inserted into a hole of the printed board, to the upper foil, and the other arm has been inserted through a second hole, which ends at the lower foil, said arm being fixed to the lower foil by soldering.

DE-A-1 065 898 is related to a method for manufacturing conductive connections between conductor foils of printed board being provided on different sides of an isolating plate by means of soldering. Soldering is provided on that side of the isolating plate being opposite to the soldering device between the conductor strip and the connector element. The soldering melts by means of the heat conducting through the connector element and connecting the connector element with the conductor strip.

It is also known to use wires connecting the upper and the lower foil in order to produce more flexible joints, but the known embodiments do not allow a rapid production by means of the wave soldering method.

The purpose of the present invention is to eliminate the above problems and to provide a joint and a method that ensure operation reliability in spite of temperature variations, and allowing simultaneously the use of an inexpensive printed board material and the application of the wave soldering method.

In order to achieve this purpose, the throughput according to the invention is characterized by the features presented in claim 1, and the characteristics of the method according to the invention are correspondingly disclosed in claim 2.

In the throughput method according to the invention, two holes are consequently required in the printed board. Into one of the holes, a sleeve is inserted in a manner known per se, and it comprises a solder fringe on the upper surface of the printed board, surrounding the sleeve. Around the other hole, whore no sleeve is provided, a solder fringe, i.e. conductor foil is disposed on the lower surface of the printed board. The second hole and the one with the sleeve are connected by means of an overshoot wire or some other component, the molten solder rising in a wave solder joint by capillary attraction along the sleeve onto the upper surface of the printed board, thus forming an upper solder fringe, and the second solder joint is produced at the second hole onto the lower surface of the board.

Thus, a flexible and reliable joint is achieved between the lower and the upper surface of the printed board. The over-shoot wire or component acts as a flexible element, which compensates the different thermal expansion properties of the various materials taking part in the joint; the printed board, the sleeve, the overshoot wire and the solder. Under these circumstances, the solder joints, when subject to temperature variations, are not subject to stresses that would cause ruptures and electric breaks.

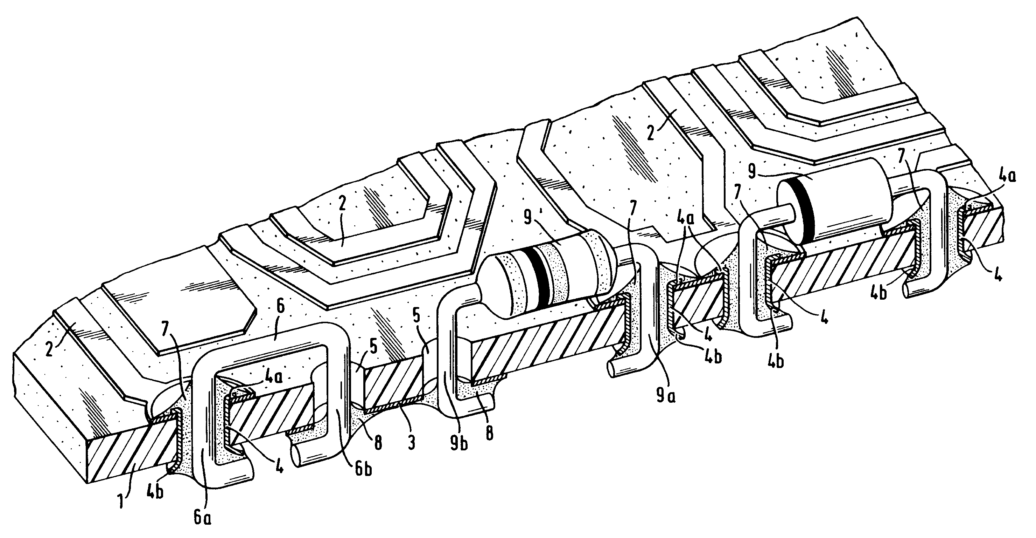

The invention and its other features and advantages are described in greater detail below and with reference to the enclosed drawing, which is a perspective and partial section view of the joint achieved according to the invention.

In the figure, reference 1 indicates a printed board, which can be for instance of FR-2 material and which comprises upper conductor foils 2 and lower conductor foils 3.

A joint produced by means of an overshoot wire is described below. In the printed board 1 two holes have been made, into one of which a metal sleeve 4 has been inserted and the other hole 5 is without a sleeve. In the sleeve 4 a planar upper flange 4a is provided, which is placed against the conductor foil 2. The lower side of the sleeve is also spread out of a flange 4b, at which no conductor foil is provided, however.

The metal overshoot wire 6 has been composed into the printed board in such a way that its one arm 6a extends through the sleeve 4 and the other arm 6b extends through the hole 5.

In the case of automatic soldering, as the solder wave sweeps the lower surface of the board, the molten solder rises along the sleeve 4 by capillary attraction, thus soldering the flange 4a to the upper foil 2 at the point 7 and simultaneously the arm 6a to the sleeve 4. At the same time the molten solder fixes the arm 6b to the lower foil 3 at the point 8.

In wave soldering, a flexible joint is thus achieved between the upper foil 2 and the lower foil 3.

Corresponding totally to the overshoot wire 6, the throughput can of course be produced by means of the component 9, as shown in the centre of the figure. The one arm or foot 9a of the component is attached by the solder 7 risen along the sleeve to the upper foil and the second arm, i.e. foot 9b, is attached by the solder 8 to the lower foil 3.

By using two sleeves 4 the component 9 can, by means of the method described above, automatically be soldered inbetween the two upper conductor foils as shown on the right side in the figure.

## Claims

1. Throughput of a two-sided printed board (1), in which the upper conductor foil (2) of the printed board is connected directly or by means of a component with the lower conductor foil (3), the upper joint (7) having been produced by a sleeve (4) inserted into a hole in the printed board (1) in such a manner that molten solder has risen through the sleeve from below the printed board (1) and has fixed the top (4a) of the sleeve to the upper conductor foil (2), and one leg (6a; 9a) of a wire (6) or the component (9) has been inserted into the sleeve (4), said leg being joined to the sleeve (4) by soldering, and a second leg (6b; 9b) of the wire (6) or component (9) has been inserted through a second hole (5) in the printed board, the second hole ending at the lower conductor foil (3), and said second leg (6b; 9b) being fixed to the lower conductor foil (3) by soldering (8), whereby no conductor foil is provided on the printed board around the lower part of the sleeve (4) nor around the top part of the second hole (5).

2. Method for producing the throughput of a two-sided printed board (1), in which the upper conductor foil (2) is connected directly or by means of a component to the lower conductor foil (3), the upper joint (7) being produced by inserting a sleeve (4) into a hole in the printed board (1) in such a manner that molten solder rises through the sleeve from below the printed board (1) and fixes the top (4a) of the sleeve to the upper conductor foil (2), and one leg (6a; 9a) of a wire (6) or a component (9) is placed into the sleeve (4), said leg being fixed to the sleeve (4) by the rising solder, a second leg (6b; 9b) of the wire (6) or component (9) is inserted through a second hole (5) in the printed board (1), said second hole ending at the lower conductor foil (3), the solder (8) fixing said second leg (6b; 9b) to the lower conductor foil (3), whereby the printed board (1) is left free from conductor foil around the lower part of the sleeve (4) and around the top part of the second hole (5).

## Patentansprüche

1. Durchverbindung einer doppelseitigen Leiterplatte (1), wobei die obere Leiterfolie (2) der Leiterplatte unmittelbar oder mittels eines Bauteils mit der unteren Leiterfolie (3) verbunden ist, wobei die obere Verbindungsstelle (7) mittels einer Hülse (4), die in ein Loch in der Leiterplatte (1) eingesetzt ist, derart hergestellt worden ist, daß geschmolzenes Lot von unterhalb der Leiterplatte (1) durch die Hülse aufgebaut worden ist und das obere Ende (4a) der Hülse an der oberen Leiterfolie (2) befestigt hat, und wobei ein Schenkel (6a; 9a) eines Drahts (6) oder des Bauteils (9) eingesetzt worden ist, wobei der Schenkel durch Verlöten mit der Hülse (4) verbunden worden ist, und ein zweiter Schenkel (6b; 9b) des Drahts (6) oder des Bauteils (9) durch eine zweite Öffnung (5) in die Leiterplatte eingesetzt worden ist, wobei das zweite Loch an der unteren Leiterfolie (3) endet, und der zweite Schenkel (6b; 9b) durch Verlöten mit der unteren Leiterfolie (3) befestigt ist, wodurch weder um den unteren Teil der Hülse (4) noch um den oberen Teil der zweiten Öffnung (5) herum eine Leiterfolie vorgesehen ist.

2. Verfahren zur Herstellung der Durchverbindung einer doppelseitigen Leiterplatte (1), bei dem die obere Leiterfolie (2) unmittelbar oder mittels eines Bauteils mit der unteren Leiterfolie (3) verbunden wird, wobei die obere Verbindungsstelle (7) durch Einsetzen einer Hülse (4) in ein Loch in der Leiterplatte (1) derart hergestellt wird, daß sich geschmolzenes Lot durch die Hülse von unterhalb der Leiterplatte (1) aufbaut und das obere Ende (4a) der Hülse an der oberen Leiterfolie (2) befestigt, und ein Schenkel (6a; 9a) eines Drahts (6) oder eines Bauteils (9) in die Hülse (4) eingesetzt wird, wobei der Schenkel an der Hülse (4) durch das sich aufbauende Lot befestigt wird, ein zweiter Schenkel (6b; 9b) des Drahts oder des Bauteils (9) durch ein zweites Loch (5) in die Leiterplatte (1) eingesetzt wird, wobei das zweite Loch an der unteren Leiterfolie (3) endet, das Lot (8) den zweiten Schenkel (6b; 9b) an der unteren Leiterfolie (3) befestigt, wodurch die Leiterplatte (1) um den unteren Teil der Hülse (4) und um den oberen Teil des zweiten Lochs (5) herum von Leiterfolie freigelassen wird.

## Revendications

1. Connexion de traversée d'un panneau à circuit imprimé double face (1), dans laquelle la feuille conductrice supérieure (2) du panneau est reliée, directement ou par le biais d'un composant, à la feuille conductrice inférieure (3), la liaison supérieure (7) étant assurée par un manchon (4) introduit dans un trou du panneau à circuit imprimé (1) de telle manière que la soudure en fusion s'est élevée dans le manchon par dessous le panneau à circuit imprimé (1) et a fixé la partie supérieure (4a) du manchon sur la feuille conductrice supérieure (2), et une patte (6a ; 9a) d'un fil (6) ou du composant (9) a été introduit dans le manchon (4), ladite patte étant reliée au manchon (4) par soudage et une seconde patte (6b ; 9b) du fil (6) ou du composant (9) a été introduite dans un deuxième trou (5) du panneau à circuit imprimé, ce second trou se terminant au niveau de la feuille conductrice inférieure (3) et ladite seconde patte (6b ; 9b) étant fixée sur la feuille conductrice inférieure (3) par la soudure (8), par lequel moyen aucune feuille conductrice n'est prévue sur le panneau à circuit imprimé autour de la partie inférieure du manchon (4) et autour de la partie supérieure du deuxième trou (5).

2. Procédé de réalisation d'une connexion de traversée d'un panneau à circuit imprimé double face (1), dans laquelle la feuille conductrice supérieure (2) est reliée, directement ou par le biais d'un composant, à la feuille conductrice inférieure (3), la liaison supérieure (7) étant obtenue par l'insertion d'un manchon (4) dans un trou du panneau à circuit imprimé (1) de telle manière que la soudure en fusion s'élève dans le manchon par dessous le panneau à circuit imprimé (1) et vienne fixer la partie supérieure (4a) du manchon sur la feuille conductrice supérieure (2), et une patte (6a ; 9a) d'un fil (6) ou d'un composant (9) est placée dans le manchon (4), ladite patte étant fixée au manchon (4) par la soudure qui s'élève, une seconde patte (6b ; 9b) du fil (6) ou du composant (9) est introduite dans un deuxième trou (5) du panneau à circuit imprimé (1), ledit deuxième trou se terminant au niveau de la feuille conductrice inférieure (3), la soudure (8) fixant ladite seconde patte (6b ; 9b) sur la feuille conductrice inférieure (3), par lequel moyen le panneau à circuit imprimé (1) est laissé dépourvue de feuille conductrice autour du manchon (4) et autour de la partie supérieure du deuxième trou (5).
